(19) Europäisches Patentamt
European Patent Office
Office européen des brevets

(11) **EP 3 404 781 B1**

(12) **FASCICULE DE BREVET EUROPEEN**

(45) Date de publication et mention
de la délivrance du brevet:
**27.11.2019 Bulletin 2019/48**

(51) Int Cl.:
*H01S 5/34* *(2006.01)*      *G02B 6/12* *(2006.01)*
*H01L 33/06* *(2010.01)*      *H04B 10/70* *(2013.01)*
*H01S 5/10* *(2006.01)*      *H01S 5/12* *(2006.01)*

(21) Numéro de dépôt: **18172548.2**

(22) Date de dépôt: **16.05.2018**

(54) **SOURCE DE LUMIÈRE GUIDÉE, SON PROCÉDÉ DE FABRICATION ET SON UTILISATION POUR L'ÉMISSION DE PHOTONS UNIQUES**

QUELLE FÜR GEFÜHRTES LICHT, IHR HERSTELLUNGSVERFAHREN UND IHRE VERWENDUNG FÜR DIE EMISSION VON EINZELNEN PHOTONEN

GUIDED LIGHT SOURCE, METHOD FOR MANUFACTURING SAME AND USE THEREOF FOR SINGLE PHOTON EMISSION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.05.2017 FR 1754421**

(43) Date de publication de la demande:
**21.11.2018 Bulletin 2018/47**

(73) Titulaire: **Commissariat à l'énergie atomique et aux énergies alternatives 75015 Paris (FR)**

(72) Inventeurs:
• **HASSAN, Karim**
  **89470 MONETEAU (FR)**
• **BOUTAMI, Salim**
  **38100 GRENOBLE (FR)**

(74) Mandataire: **Brevalex**
  **95, rue d'Amsterdam**
  **75378 Paris Cedex 8 (FR)**

(56) Documents cités:
**FR-A1- 2 933 816      US-A1- 2008 096 308**

## Description

## DOMAINE TECHNIQUE

Le domaine de l'invention est celui des sources de lumière, et plus particulièrement celui des sources de photons uniques.

## ÉTAT DE LA TECHNIQUE ANTÉRIEURE

Les sources de photons uniques sont capables d'émettre un seul photon à la fois. Elles sont généralement constituées d'un émetteur de type boîte quantique, et l'émission d'un photon y est réalisée à partir d'une paire électron-trou injectée.

Ces sources ont pour intérêt l'étude fondamentale de processus optiques et quantiques, mais également la cryptographie quantique. En effet, si l'on est capable de transmettre de l'information en bits constitués chacun d'un photon unique, on peut se prémunir, ou du moins détecter, l'interception de messages.

Pour qu'une source de photons uniques soit utilisable, il faut être capable de collecter efficacement le photon émis. Pour cela, la source doit pouvoir émettre le photon de manière directive.

Une source de photons uniques bien connue est décrite dans l'article « Quantum dots as single-photon sources for quantum information processing » (D C Unitt et al 2005 J. Opt. B: Quantum Semiclass. Opt. 7 S129). Elle est constituée d'un pilier formé par gravure ionique réactive, avec une boîte quantique en son sein entourée de miroirs de Braggs. Les miroirs de Bragg permettent de constituer une cavité Fabry-Pérot qui exacerbe la probabilité d'émission de la boîte quantique dans ce mode de résonance. Cependant, on s'aperçoit que ce type de source diverge. De plus, de par la forte résonance de cette source (fort temps de vie du photon émis dans la cavité), il existe un risque que le photon soit diffracté par la rugosité de bord de gravure du pilier.

Un autre type de source de photons uniques est présenté dans l'article « A highly efficient single-photon source based on a quantum dot in a photonic nanowire » (J. Claudon et al., Nature Photonics 4, 174 - 177 (2010)). Cette source prend la forme d'un pilier dont la pointe supérieure est affinée par des conditions adéquates de gravure. Un miroir est disposé sous le pilier pour réfléchir la lumière vers le haut. Cette source est peu résonnante, ce qui évite de diffracter la lumière par rugosité. Par ailleurs, l'affinement en pointe du sommet du pilier permet d'élargir spatialement le mode du pilier, et donc de le rendre moins divergent angulairement. Cette source présente donc une bonne directivité d'émission.

Cependant le positionnement de la boîte quantique au sein d'un pilier nécessite un alignement précis, ce qui n'est pas chose aisée. Il est par ailleurs difficile de contrôler avec précision la forme donnée à la pointe du pilier, de sorte que la collimation de la source ne peut être bien contrôlée.

Par ailleurs, FR 2 933 816 A1 décrit une source de lumière guidée, comprenant en particulier une source optique associée à un guide d'onde discoïde, un guide d'onde annulaire entourant ledit guide d'onde discoïde et un guide d'onde de sortie optiquement couplé au guide d'onde annulaire.

## EXPOSÉ DE L'INVENTION

Un objectif de l'invention est de proposer une source de lumière qui ne présente pas ces inconvénients. A cet effet, l'invention propose une source de lumière qui n'émet pas en champ libre mais de manière guidée. Plus particulièrement, l'invention propose une source de lumière guidée comprenant au moins une boîte quantique associée à un guide d'onde discoïde de manière à assurer une propagation cylindrique d'un front d'onde émis par l'au moins une boite quantique dans le guide d'onde discoïde. Un guide d'onde annulaire entoure le guide d'onde discoïde et présente un réseau de couplage (T) formé sur sa périphérie intérieure pour recevoir ledit front d'onde en incidence normale. Un guide d'onde de sortie est optiquement couplé au guide d'onde annulaire.

Certains aspects préférés mais non limitatifs de cette source sont les suivants :

- le guide d'onde annulaire est ouvert pour former deux extrémités de couplage, et la source comprend en outre un coupleur raccordé, d'une part, aux deux extrémités de couplage du guide d'onde annulaire et, d'autre part, au guide d'onde de sortie, ledit coupleur étant configuré pour combiner des faisceaux circulant en sens inverse dans le guide d'onde annulaire en un unique faisceau circulant dans le guide d'onde de sortie ;
- le coupleur est une jonction Y, ou un coupleur à interférences multimodes ;
- un miroir entoure le guide d'onde annulaire, par exemple à une distance optique quart d'onde du guide d'onde annulaire
- le guide d'onde discoïde et le guide d'onde annulaire sont espacés d'une distance optique inférieure à une distance quart d'onde ;
- l'au moins une boite quantique est agencée dans le guide d'onde discoïde, ou espacée du guide d'onde discoïde d'une distance optique inférieure à une distance quart d'onde ;
- le guide d'onde annulaire est en un matériau semi-conducteur dopé ;
- le guide d'onde annulaire est un guide d'onde en arête ;
- un plot de contact électrique est agencé au-dessus de l'au moins une boîte quantique ;
- elle comprend une unique boîte quantique.

L'invention s'étend à l'utilisation de cette source pour l'émission d'une séquence de photons uniques, par exemple dans un processus de cryptographie quantique. L'invention porte également sur un procédé de fabrication d'une telle source de lumière guidée.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- la figure 1 est une vue de dessus d'une source de lumière guidée selon un mode de réalisation possible de l'invention ;
- la figure 2 est un schéma illustrant la propagation d'un front d'onde émis par une boîte quantique dans la source de la figure 1 ;
- les figures 3a-3g illustrent un premier exemple d'un procédé de fabrication d'une source conforme à l'invention ;
- les figures 4a-4h illustrent un second exemple d'un procédé de fabrication d'une source conforme à l'invention.

## EXPOSÉ DÉTAILLÉ DE MODES DE RÉALISATION PARTICULIERS

L'invention concerne une source de lumière guidée, par exemple une source destinée à émettre une séquence de photons uniques.

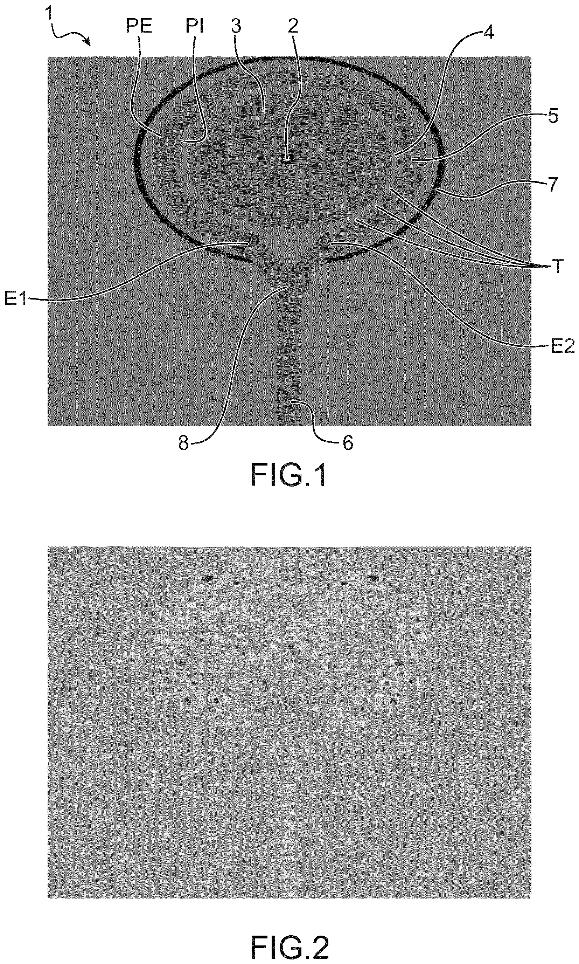

On a représenté sur la figure 1 une vue de dessus d'une source 1 conforme à l'invention. Elle comprend au moins une boîte quantique 2 associée à un guide d'onde discoïde 3 de manière à assurer une propagation cylindrique d'un front d'onde émis par l'au moins une boite quantique dans le guide d'onde discoïde. Le guide d'onde discoïde est réalisé en un matériau cœur, par exemple en silicium. Il est entouré d'une gaine, par exemple en silice.

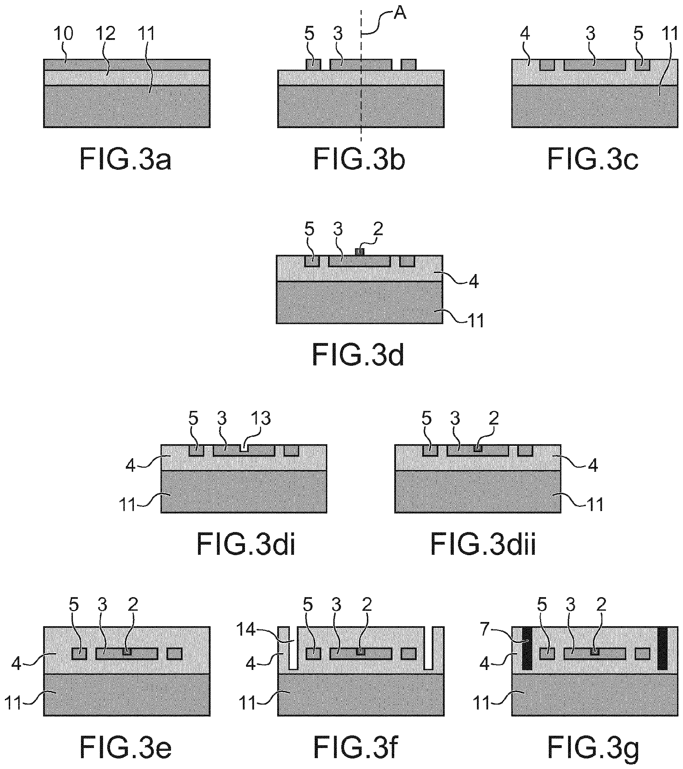

Le guide d'onde discoïde 3 prend la forme d'un pavé de section globalement circulaire. Il présente un axe de symétrie référencé A sur la figure 3b. Sa section transversale, dans un plan orthogonal à l'axe de symétrie, prend la forme d'une ellipse dont le rapport entre petit et grand rayons est compris entre 0,8 et 1. L'axe de symétrie passe par le centre de l'ellipse. Le guide d'onde discoïde présente par exemple une épaisseur de 3 $\mu$m. Sa section transversale peut prendre la forme d'un cercle, dont le diamètre est par exemple de 3,5 $\mu$m, auquel cas il forme un cylindre.

La ou les boîtes quantiques 2 sont agencées en-dessous, en-dessus (c'est le cas pour la figure 1) ou dans le guide d'onde discoïde 3. Elles sont idéalement placées au niveau de l'axe de symétrie. Le front d'onde émis par une boîte quantique se propage de manière cylindrique dans le guide d'onde discoïde, depuis l'axe de symétrie vers le pourtour du guide d'onde discoïde.

Lorsque placée en dessous ou en dessus du guide d'onde discoïde, une boîte quantique est au contact du guide d'onde discoïde ou espacée de celui-ci d'une distance inférieure à une distance optique quart d'onde.

La source 1 peut comprendre une unique boîte quantique, formant alors une source de photons uniques. Elle peut comprendre une pluralité de boîtes quantiques arrangées sous la forme d'un agrégat ou d'un ensemble organisé de boîtes quantiques.

La source 1 comporte par ailleurs un guide d'onde annulaire 5 qui entoure le guide d'onde discoïde 3, et est séparé de celui-ci par la gaine 4 d'une distance optique au plus quart d'onde pour éviter des fuites verticales de lumière. Le guide d'onde annulaire 5 présente une périphérie (face latérale) extérieure PE, une périphérie intérieure PI tournée vers le guide d'onde discoïde 3 et une surface supérieure reliant les périphéries extérieure et intérieure. Il présente avantageusement une même épaisseur que le guide d'onde discoïde, et une largeur par exemple de 0,5 $\mu$m.

Un réseau de couplage (connu sous le terme anglo-saxon de « grating coupler ») est formé sur la périphérie intérieure PI du guide d'onde annulaire 5. Un tel réseau est généralement réalisé sur la surface supérieure d'un guide d'onde pour permettre de réaliser l'extraction (respectivement l'injection) de lumière depuis (vers) le guide d'onde vers (depuis) une fibre optique. Pour augmenter l'efficacité, cette extraction/injection se fait à un angle $\Theta$ par rapport à la normale au réseau en venant incliner la fibre optique. La période du réseau s'exprime alors selon $P = \dfrac{\lambda}{n_{eff} - n \sin\theta}$ où $n_{eff}$ est l'indice effectif du mode, n l'indice du superstrat, et $\theta$ l'angle d'injection ou extraction.

Dans le cadre de l'invention, le réseau de couplage comprend, le long de la périphérie intérieure, une succession de tranchées T gravées sur toute l'épaisseur du guide d'onde annulaire. Le réseau de couplage ainsi formé sur la périphérie intérieure du guide annulaire 5 reçoit le front d'onde, qui s'est propagé de manière cylindrique dans le guide d'onde discoïde 3, en incidence normale. On a donc $\Theta=0°$ et le réseau est conçu pour présenter une période $P = \dfrac{\lambda}{n_{eff}}$. Un exemple de réalisation est un guide silicium entouré de silice, une longueur d'onde de travail $\lambda=1.55\mu$m, une périodicité du réseau P=530nm, un facteur de remplissage de 50% et une profondeur de gravure de 90nm (depuis la face latérale intérieure du guide d'onde annulaire).

En injection normale, pour des raisons de symétrie, 50% de la lumière injectée dans le guide d'onde annulaire 5 part dans un sens et 50% dans l'autre sens, avec la même phase. Ainsi, lorsque la boîte quantique émet une onde, la lumière est injectée normalement dans le guide d'onde annulaire 5 où elle se propage selon deux modes : un mode propagatif dans un sens de l'anneau et un mode contrapropagatif dans le sens inverse.

La source de lumière 1 comporte en outre un guide d'onde de sortie 6 optiquement couplé au guide d'onde annulaire, par exemple un guide rectiligne. Ainsi la lumière émise par la ou les boîtes quantiques est couplée dans le guide de sortie, réalisant ainsi une source de lumière guidée.

De préférence, la source de lumière comporte en outre un miroir 7 qui entoure le guide d'onde annulaire pour renvoyer la lumière vers le guide d'onde annulaire. Le miroir 7 est placé à une distance optique quart d'onde de la périphérie extérieure du guide d'onde annulaire et est espacé de celle-ci par du matériau gaine, typiquement de la silice. Le miroir peut être formé de métal (par exemple en cuivre, en or, en titane, en tungstène ou encore en oxyde d'indium-étain), et ainsi constituer une enceinte métallique permettant d'assurer que la lumière ne fuit pas de la source. Dans une variante de réalisation, le miroir est un miroir de Bragg constitué d'une alternance radiale de couches d'indices optiques différents, par exemple des couches de silice et de silicium.

Dans une mode de réalisation, et comme représenté sur la figure 1, le guide d'onde annulaire 5 est ouvert pour former deux extrémités de couplage E1, E2 (il est partiellement annulaire, et couvre de préférence au moins 75% de la circonférence d'un anneau). Les deux extrémités de couplage E1, E2 sont de préférence symétriques par rapport à un plan sagittal médian de l'anneau (plan orthogonal au plan de la figure 1 et contenant l'axe de symétrie). Le réseau de couplage s'étend d'une extrémité de couplage à l'autre le long de la périphérie intérieure du guide d'onde annulaire.

La source comprend en outre un coupleur 8 à 2 entrées et 1 sortie raccordé, d'une part, aux deux extrémités de couplage E1, E2 du guide d'onde annulaire 5 et, d'autre part, au guide d'onde de sortie, ledit coupleur 8 étant configuré pour combiner les faisceaux circulant en sens inverse dans le guide d'onde annulaire en un unique faisceau circulant dans le guide d'onde de sortie. En d'autres termes, le coupleur 8 permet de recombiner dans le guide d'onde de sortie les deux modes, propagatif et contrapropagatif, circulant dans le guide d'onde annulaire. Le coupleur 8 peut être une jonction Y, ou un coupleur à interférences multimode (MMI pour « MultiMode Interference »).

Dans une variante de réalisation, le guide d'onde annulaire est parfaitement annulaire et est couplé de manière évanescente à un guide d'onde rectiligne. Dans un tel cas de figure, la lumière circuler dans les deux modes propagatif et contrapropagatif dans le guide rectiligne. Un coupleur à deux entrées, chacune raccordée à une extrémité du guide d'onde rectiligne, et une sortie, raccordée à un guide d'onde de sortie, permet de combiner les faisceaux circulant en sens inverse dans le guide d'onde rectiligne en un unique faisceau circulant dans le guide d'onde de sortie.

Dans une autre variante de réalisation qui n'exploite pas de coupleur, l'une des extrémités de couplage du guide d'onde annulaire est raccordée au guide d'onde de sortie tandis qu'un miroir est positionné au niveau de l'autre extrémité de couplage.

On a représenté sur la figure 2 une simulation, par calcul de différences finies dans le domaine temporel, à la longueur d'onde télécom de $\lambda$=1,55 $\mu$m de la source de lumière guidée de la figure 1. Cette simulation confirme un bon couplage optique avec le guide de sortie 6 puisque 80% de la lumière émise par la boîte quantique se retrouve guidée dans le guide d'onde de sortie.

On a représenté sur les figures 3a-3g un premier exemple de réalisation d'un procédé de fabrication d'une source de lumière guidée conforme à l'invention. Le procédé débute (figure 3a) par la fourniture d'un substrat silicium-sur-isolant (SOI pour « Silicon On Insulator ») qui comprend une couche de silicium superficielle 10 séparée d'un substrat massif de silicium 11 par une couche d'oxyde enterrée 12. En référence à la figure 3b, on procède à la gravure de la couche de silicium superficielle 10 pour définir les différentes structures de la source de lumière guidée, à savoir le guide d'onde discoïde 3, le guide d'onde annulaire 5 dont la périphérie intérieure est gravée pour y définir le réseau de couplage, le guide d'onde de sortie, le coupleur et le cas échéant les couches en silicium destinées à former un miroir de Bragg. En référence à la figure 3c, on vient ensuite déposer le matériau cœur, ici de la silice, et planariser ce dépôt. On vient ensuite positionner la ou les boîtes quantiques 2 au centre du guide d'onde discoïde, en réalisant par exemple le dépôt d'une solution colloïdale de boîtes quantiques sur le substrat.

Dans une variante illustrée sur la figure 3d, une boîte quantique est déposée sur le guide d'onde discoïde 3 au niveau de l'axe de symétrique A. Dans une variante non illustrée, une résine peut être déposée sur la structure de la figure 3c et gravée à l'aplomb du guide d'onde discoïde 3 au niveau de l'axe de symétrique A. Par capillarité, une boîte quantique vient se positionner dans le trou gravé dans la résine. On retire ensuite la résine pour aboutir à une structure identique à celle représentée sur la figure 3d. Dans une autre variante de réalisation illustrée sur les figures 3di et 3dii, on vient graver le guide d'onde discoïde 3 pour y former un trou au niveau de l'axe de symétrie. Par capillarité, la boîte quantique 2 vient naturellement se positionner dans le trou.

On réalise ensuite un nouveau dépôt de silice pour encapsuler l'ensemble des guides d'onde de matériau gaine (figure 3e). Lorsque l'on a recours à un miroir métallique, on procède à la gravure d'une tranchée 14 qui entoure le guide d'onde annulaire 5 (figure 3f), puis au remplissage de la tranchée (ou un simple placage de ses parois) par un métal 7 (figure 3g), par exemple du cuivre. On peut ensuite éliminer ou conserver le métal présent en surface suite au dépôt.

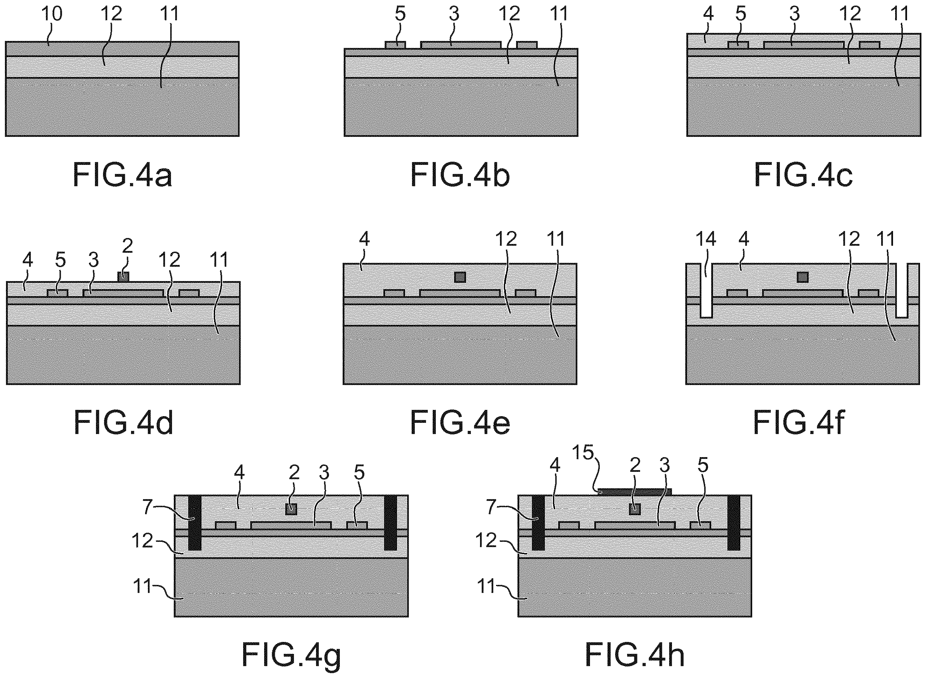

On a représenté sur les figures 4a-4h un second exemple de réalisation d'un procédé de fabrication d'une source de lumière guidée conforme à l'invention. Ce second exemple de réalisation rend possible un pompage électrique, plutôt qu'optique, pour exciter la boîte quantique au moyen d'une injection électrique par effet tunnel et permettre l'émission d'un photon.

Ce procédé débute (figure 4a) par la fourniture d'un substrat SOI dont la couche superficielle 10 est dopée. En référence à la figure 4b, on procède à la gravure de la couche de silicium superficielle pour définir les différentes structures de la source de lumière guidée, à savoir le guide d'onde discoïde 3, le guide d'onde annulaire 5 dont la périphérie intérieure est gravée pour y définir le réseau de couplage, le guide d'onde de sortie et le coupleur. Le guide d'onde discoïde est ici un guide d'onde en arrête (« rib » selon la terminologie anglo-saxonne) pour permettre la réalisation d'un contact électrique. On procède ensuite au dépôt d'une fine couche de silice 4 (figure 4c) puis au positionnement de la boîte quantique (figure 4d), avec éventuellement une pré-structuration de la silice ou d'une couche de résine pour faciliter ce positionnement. On procède à un nouveau dépôt de silice (figure 4e), à la gravure d'une tranchée 14 entourant le guide d'onde annulaire (figure 4f), au remplissage de la tranchée par un métal pour former le miroir 7 (figure 4g) et enfin au dépôt d'un plot de contact électrique supérieur 15 à l'aplomb de la boîte quantique (figure 4h). Le miroir métallique 7 au contact du guide d'onde discoïde en arête dopé permet la prise de contact électrique. Ces contacts électriques (plot 15 et prise de contact via le miroir 7) permettent de réaliser une injection électrique dans la boîte, le courant ne pouvant passer du plot 15 au guide d'onde discoïde en raison de la couche diélectrique 4, sauf par la boîte quantique par effet tunnel. En forçant ainsi le courant à passer par la boîte, une bonne efficacité d'injection est assurée, l'injection d'une paire électron-trou permettant l'émission d'un photon.

L'invention porte également sur l'utilisation de la source telle que décrite précédemment pour l'émission d'une séquence de photons uniques.

Le dispositif peut alors être constitué d'un laser de pompe impulsionnel et d'un couple de deux détecteurs rapides de type APD (photodiode à avalanche) couplées à un compteur d'impulsions assurant la mesure de la fonction de corrélation. Les deux détecteurs sont chacun situés de part et d'autre d'une lame semi-réfléchissante recevant le flux de photons en provenance de l'échantillon excité par le laser. Dans une réalisation alternative au pompage optique, et comme décrit précédemment, on peut réaliser une injection électrique par effet tunnel dans la boite quantique.

L'invention n'est pas limitée à la source de lumière guidée et à son utilisation, mais s'étend également à un circuit photonique intégrant une telle source de lumière ainsi qu'au procédé de fabrication d'une telle source et notamment à un procédé de fabrication d'une source de lumière guidée, comprenant :

la formation d'un guide d'onde discoïde 3, d'un guide d'onde annulaire 5 entourant le guide d'onde discoïde et d'un guide d'onde de sortie 6 optiquement couplé au guide d'onde annulaire ;
le placement d'au moins une boîte quantique 2 de manière à assurer une propagation cylindrique d'un front d'onde émis par l'au moins une boite quantique dans le guide d'onde discoïde ; et
la formation d'un réseau de couplage sur une périphérie intérieure PI du guide d'onde annulaire 5 pour recevoir ledit front d'onde en incidence normale.

**Revendications**

1. Source de lumière guidée (1), comprenant :

   - au moins une boîte quantique (2) associée à un guide d'onde discoïde (3) de manière à assurer une propagation cylindrique d'un front d'onde émis par l'au moins une boite quantique dans le guide d'onde discoïde ;
   - un guide d'onde annulaire (5) entourant ledit guide d'onde discoïde et présentant un réseau de couplage (T) formé sur sa périphérie intérieure pour recevoir ledit front d'onde en incidence normale ;
   - un guide d'onde de sortie (6) optiquement couplé au guide d'onde annulaire.

2. Source selon la revendication 1 dans laquelle le guide d'onde annulaire (5) est ouvert pour former deux extrémités de couplage (E1, E2), et qui comprend en outre un coupleur (8) raccordé, d'une part, aux deux extrémités de couplage (E1, E2) du guide d'onde annulaire et, d'autre part, au guide d'onde de sortie (6), ledit coupleur étant configuré pour combiner des faisceaux circulant en sens inverse dans le guide d'onde annulaire en un unique faisceau circulant dans le guide d'onde de sortie.

3. Source selon la revendication 2, dans laquelle le coupleur (8) est une jonction Y.

4. Source selon la revendication 2, dans laquelle le coupleur (8) est un coupleur à interférences multimodes.

5. Source selon l'une des revendications 1 à 3, comprenant un miroir (7) qui entoure le guide d'onde annulaire (5).

6. Source selon la revendication 5, dans laquelle le miroir (7) est agencé à une distance optique quart d'onde du guide d'onde annulaire (5).

**7.** Source selon l'une des revendications 1 à 6, dans laquelle le guide d'onde discoïde (3) et le guide d'onde annulaire (5) sont espacés d'une distance optique inférieure à une distance quart d'onde.

**8.** Source selon l'une des revendications 1 à 7, dans laquelle l'au moins une boite quantique (2) est agencée dans le guide d'onde discoïde.

**9.** Source selon l'une des revendications 1 à 7, dans laquelle l'au moins une boite quantique (2) est espacée du guide d'onde discoïde d'une distance optique inférieure à une distance quart d'onde.

**10.** Source selon la revendication 9, dans laquelle le guide d'onde annulaire est en un matériau semi-conducteur dopé.

**11.** Source selon la revendication 9, dans laquelle le guide d'onde annulaire est un guide d'onde en arête.

**12.** Source selon l'une des revendications 10 et 11, comprenant en outre un plot de contact électrique (15) agencé au-dessus de l'au moins une boîte quantique.

**13.** Source selon l'une des revendications 1 à 12, comprenant une unique boîte quantique.

**14.** Utilisation de la source selon la revendication 13, pour l'émission d'une séquence de photons uniques.

**15.** Procédé de fabrication d'une source de lumière guidée (1), comprenant :

- la formation d'un guide d'onde discoïde (3), d'un guide d'onde annulaire (5) entourant le guide d'onde discoïde et d'un guide d'onde de sortie (6) optiquement couplé au guide d'onde annulaire ;
- le placement d'au moins une boîte quantique (2) de manière à assurer une propagation cylindrique d'un front d'onde émis par l'au moins une boite quantique dans le guide d'onde discoïde ; et
- la formation d'un réseau de couplage (T) sur une périphérie intérieure (PI) du guide d'onde annulaire (5) pour recevoir ledit front d'onde en incidence normale.

**Patentansprüche**

**1.** Geführte Lichtquelle (1), enthaltend:

- zumindest einen Quantenpunkt (2), der einem scheibenförmigen Wellenleiter (3) zugeordnet ist, um eine zylindrische Ausbreitung einer Wellenfront zu gewährleisten, die von dem zumindest einen Quantenpunkt in dem scheibenförmigen Wellenleiter emittiert wird;
- einen ringförmigen Wellenleiter (5), der den scheibenförmigen Wellenleiter umgibt und ein Koppelnetzwerk (T) aufweist, das an seinem inneren Umfang ausgebildet ist, um die Wellenfront bei normalem Einfall zu empfangen;
- einen Ausgangswellenleiter (6), der optisch mit dem ringförmigen Wellenleiter gekoppelt ist.

**2.** Quelle nach Anspruch 1, wobei der ringförmige Wellenleiter (5) offen ist, um zwei Kopplungsenden (E1, E2) zu bilden, und ferner einen Koppler (8) enthält, der einerseits mit beiden Kopplungsenden (E1, E2) des ringförmigen Wellenleiters und andererseits mit dem Ausgangswellenleiter (6) verbunden ist, wobei der Koppler dazu ausgelegt ist, um Strahlen, die in entgegengesetzten Richtungen im ringförmigen Wellenleiter fließen, zu einem einzelnen Strahl zu kombinieren, der im Ausgangswellenleiter fließt.

**3.** Quelle nach Anspruch 2, wobei der Koppler (8) eine Y-Verbindung ist.

**4.** Quelle nach Anspruch 2, wobei der Koppler (8) ein Multimode-Interferenzkoppler ist.

**5.** Quelle nach einem der Ansprüche 1 bis 3, enthaltend einen Spiegel (7), der den ringförmigen Wellenleiter (5) umgibt.

**6.** Quelle nach Anspruch 5, wobei der Spiegel (7) in einem optischen Viertelwellenabstand vom ringförmigen Wellenleiter (5) angeordnet ist.

**7.** Quelle nach einem der Ansprüche 1 bis 6, wobei der scheibenförmige Wellenleiter (3) und der ringförmige Wellenleiter (5) um einen optischen Abstand beabstandet sind, der geringer als ein Viertelwellenabstand ist.

**8.** Quelle nach einem der Ansprüche 1 bis 7, wobei der zumindest eine Quantenpunkt (2) in dem scheibenförmigen Wellenleiter angeordnet ist.

**9.** Quelle nach einem der Ansprüche 1 bis 7, wobei der zumindest eine Quantenpunkt (2) um einen optischen Abstand, der geringer als ein Viertelwellenabstand ist, von dem scheibenförmigen Wellenleiter beabstandet ist.

**10.** Quelle nach Anspruch 9, wobei der ringförmige Wellenleiter ein dotiertes Halbleitermaterial ist.

**11.** Quelle nach Anspruch 9, wobei der ringförmige Wellenleiter ein Kantenwellenleiter ist.

**12.** Quelle nach einem der Ansprüche 10 und 11, ferner enthaltend ein elektrisches Kontaktstück (15), das oberhalb des zumindest einen Quantenpunktes angeordnet ist.

**13.** Quelle nach einem der Ansprüche 1 bis 12, enthaltend einen einzigen Quantenpunkt.

**14.** Verwendung der Quelle nach Anspruch 13 zur Emission einer Sequenz von einzelnen Photonen.

**15.** Verfahren zum Herstellen einer geführten Lichtquelle (1), umfassend:

- Ausbilden eines scheibenförmigen Wellenleiters (3), eines ringförmigen Wellenleiters (5), der den scheibenförmigen Wellenleiter umgibt, und eines Ausgangswellenleiters (6), der optisch mit dem ringförmigen Wellenleiter gekoppelt ist;
- Anordnen von zumindest einem Quantenpunkt (2) derart, dass eine zylindrische Ausbreitung einer Wellenfront gewährleistet wird, die von dem zumindest einen Quantenpunkt in dem scheibenförmigen Wellenleiter emittiert wird;
- Ausbilden eines Koppelnetzwerks (T) an einem inneren Umfang (PI) des ringförmigen Wellenleiters (5), um die Wellenfront bei normalem Einfall zu empfangen.

**Claims**

**1.** Guided light source (1), comprising:

- at least one quantum box (2) associated with a discoid wave guide (3) to achieve cylindrical propagation of a wave front emitted by the at least one quantum box in the discoid wave guide;
- an annular wave guide (5) surrounding said discoid wave guide and having a grating coupler (T) formed on its internal periphery to receive said wave front in normal incidence;
- an output wave guide (6) optically coupled to the annular wave guide.

**2.** Guided light source according to claim 1 in which the annular waveguide (5) is open to form two coupling ends (E1, E2), and further comprising a coupler (8) having a first side connected to the two coupling ends (E1, E2) of the annular wave guide and a second side connected to the output wave guide (6), said coupler being configured to combine beams circulating in opposite direction in the annular wave guide into a single beam circulating in the output wave guide.

**3.** Guided light source according to claim 2, in which the coupler (8) is a Y junction.

**4.** Guided light source according to claim 2, in which the coupler (8) is a multimode interference coupler.

**5.** Guided light source according to one of claims 1 to 3, further comprising a mirror (7) that surrounds the annular wave guide (5).

**6.** Guided light source according to claim 5, in which the mirror (7) is arranged at a quarter wave optical distance from the annular wave guide (5).

**7.** Guided light source according to one of claims 1 to 6, in which the discoid wave guide (3) and the annular wave guide (5) are separated from each other by an optical distance less than a quarter wavelength distance.

**8.** Guided light source according to one of claims 1 to 7, in which the at least one quantum box (2) is arranged in the discoid wave guide.

**9.** Guided light source according to one of claims 1 to 7, in which the at least one quantum box (2) and the discoid wave guide are separated from each other by an optical distance less than a quarter wavelength distance.

**10.** Guided light source according to claim 9, in which the annular wave guide is made of doped semiconductor material.

**11.** Guided light source according to claim 9, in which the annular wave guide is a rib wave guide.

**12.** Guided light source according to one of claims 10 and 11, further comprising an electrical contact pad (15) arranged above the at least one quantum box.

**13.** Guided light source according to one of claims 1 to 12, comprising a single quantum box.

**14.** Use of the source according to claim 13, for the emission a sequence of single photons.

**15.** Method of fabrication of a guided light source (1), comprising:

- forming a discoid wave guide (3), an annular wave guide (5) surrounding the discoid wave guide and an output wave guide (6) optically coupled to the annular wave guide;
- positioning at least one quantum box (2) to achieve cylindrical propagation of a wave front emitted by the at least one quantum box in the discoid wave guide; and
- forming a grating coupler (T) on an internal periphery (PI) of the annular wave guide (5) to receive said wave front in normal incidence.

FIG.1

FIG.2

FIG.3a

FIG.3b

FIG.3c

FIG.3d

FIG.3di

FIG.3dii

FIG.3e

FIG.3f

FIG.3g

FIG.4a

FIG.4b

FIG.4c

FIG.4d

FIG.4e

FIG.4f

FIG.4g

FIG.4h

EP 3 404 781 B1

## RÉFÉRENCES CITÉES DANS LA DESCRIPTION

**Documents brevets cités dans la description**

- FR 2933816 A1

**Littérature non-brevet citée dans la description**

- **D C UNITT et al.** Quantum dots as single-photon sources for quantum information processing. *J. Opt. B: Quantum Semiclass. Opt.,* 2005, vol. 7, S129

- **J. CLAUDON et al.** A highly efficient single-photon source based on a quantum dot in a photonic nanowire. *Nature Photonics,* 2010, vol. 4, 174-177